# FASCICULE DE BREVET EUROPEEN

(11) **EP 2 771 910 B1**
(45) Date de publication et mention de la délivrance du brevet: **26.08.2015**
(21) Numéro de dépôt: 12775520.5
(22) Date de dépôt: 24.10.2012
(51) Int. Cl.: H01L 21/762, H01L 21/20

(54) **PROCEDE DE COLLAGE DIRECT D'UNE COUCHE D'OXYDE DE SILICIUM**
VERFAHREN ZUM DIREKTEN BONDEN EINER SILICIUMOXIDSCHICHT
METHOD FOR THE DIRECT BONDING OF A SILICON OXIDE LAYER

(30) Priorité: 26.10.2011 FR 1159723
(43) Date de publication de la demande: 03.09.2014
(73) Titulaire: Commissariat à l'Énergie Atomique et aux Énergies Alternatives, 75015 Paris (FR)
(72) Inventeur: SABBIONE, Chiara, 14100 ASTI (IT); DI CIOCCIO, Léa, F-38330 Saint Ismier (FR); NIETO, Jean-Pierre, F-73110 La Rochette (FR); VANDROUX, Laurent, F-38570 Le Cheylas (FR)
(74) Mandataire: Ahner, Philippe
(86) Numéro de dépôt international: PCT/EP2012/071062
(87) Numéro de publication internationale: WO 2013/060726

(56) Documents cités:
- WO-A2-2008/021747
- US-A- 5 383 993

## Description

### DOMAINE TECHNIQUE

L'invention concerne un procédé de collage direct entre au moins une première couche composée d'oxyde de silicium et une deuxième couche de matériau présentant un caractère hydrophile. L'invention permet par exemple de solidariser deux substrats sur lesquels sont réalisés la première couche d'oxyde de silicium et la deuxième couche de matériau, avec une grande énergie de collage.

### ÉTAT DE LA TECHNIQUE ANTÉRIEURE

Le collage direct, également appelé collage moléculaire ou collage par adhérence moléculaire, consiste à solidariser deux surfaces de matériau l'une contre l'autre sans couche adhésive intermédiaire entre ces deux surfaces. Dans ce type de collage, l'adhérence est obtenue grâce au fait que les surfaces à coller sont suffisamment lisses (comprenant typiquement une rugosité inférieure à 6 nm RMS), exemptes de particules et/ou de contaminations, et rapprochées l'une de l'autre telles que des forces attractives d'interaction électronique entre des atomes ou molécules des deux surfaces à coller se créent, par exemple des forces de Van der Waals, et ce à température et pression ambiantes.

Un tel collage direct est utilisé dans de nombreuses applications pour solidariser deux éléments comprenant notamment des couches d'oxyde déposées sur ces éléments. Un collage direct est un collage de type hydrophile car il réalise l'adhérence de surfaces hydrophiles entre elles, c'est-à-dire des surfaces ayant une capacité à se lier avec de l'eau (par un mécanisme d'adsorption).

Lorsque deux éléments, par exemple des substrats composés de semi-conducteur, à solidariser l'un avec l'autre présentent des topologies en surface, il est possible de déposer des couches d'oxyde sur ces topologies, puis de procéder à une planarisation des oxydes déposés. De cette façon, on peut obtenir des surfaces planes, dont la topologie a été lissée, aptes à être collées par collage direct l'une contre l'autre.

De plus, il arrive que les éléments à solidariser soient déjà recouverts d'une couche d'oxyde, de nitrure ou d'oxynitrure. Il est dans ce cas intéressant de pouvoir effectuer le collage à partir de ces couches du fait qu'il est parfois impossible ou trop coûteux de supprimer ces couches.

Les couches d'oxyde utilisées pour un tel collage direct peuvent être obtenues par des dépôts d'oxyde de silicium de type PECVD (dépôt chimique en phase vapeur assisté par plasma) mis en oeuvre à des températures relativement basses, généralement inférieures à environ 400°C, afin de ne pas endommager des composants, des interconnexions ou encore des dépôts d'autres matériaux, réalisés sur les éléments à solidariser.

Toutefois, en fonction des conditions dans lesquelles les couches d'oxyde ont été réalisées, ainsi que des équipements et des éléments utilisés, les couches d'oxyde peuvent présenter des énergies de collage différentes.

Après le collage, les substrats solidarisés peuvent être soumis à un traitement thermique également mis en oeuvre à une température relativement basse (par exemple inférieure à environ 400°C), pour éviter tout endommagement des éléments formés sur les substrats. Un tel traitement thermique permet d'augmenter l'énergie de collage obtenue. Toutefois, il arrive que ce traitement thermique réalisé après le collage entraîne la formation de défauts au niveau des interfaces entre l'oxyde et le semi-conducteur. Afin de prévenir la formation de ces défauts, la seule technique connue consiste à densifier les couches d'oxyde par un autre traitement thermique réalisé avant le collage.

Toutefois, l'ajout d'un tel traitement thermique mis en oeuvre avant le procédé de collage représente un inconvénient en termes de coûts, durée, etc.

US5383993 divulgue un procédé de collage de deux couches une couche étant composée d'oxyde de silicium, comprenant une étape dans laquelle la couche d'oxyde est trempé dans l'eau avant le collage.

### EXPOSÉ DE L'INVENTION

Un but de la présente invention est de proposer un procédé de collage direct entre au moins une première couche composée d'oxyde de silicium et une deuxième couche de matériau présentant un caractère hydrophile, permettant d'obtenir une importante énergie de collage entre ces deux couches et éviter la formation de défauts ultérieurs dans la structure obtenue, par exemple au cours d'un traitement thermique réalisé après le collage, et cela sans avoir à réaliser un traitement thermique spécifique pour densifier la première couche et la deuxième couche.

Pour cela, la présente invention propose un procédé de collage direct entre au moins une première couche composée d'oxyde de silicium et une deuxième couche de matériau présentant un caractère hydrophile, comprenant au moins les étapes de :
- réalisation de la première couche sur un premier substrat telle que la valeur de l'absorbance de cette première couche, à une fréquence de vibration de liaisons silanols présentes dans la première couche, soit égale ou supérieure à environ 1,5.10⁻⁵ nm⁻¹;
- collage direct entre la première couche et la deuxième couche.

L'expression « caractère hydrophile » signifie que de l'angle de contact de goutte est de préférence inférieur à environ 5°.

En réalisant la première couche composée d'oxyde de silicium telle qu'elle présente une telle absorbance (comportant un pic de valeur égale ou supérieure à environ 1,5.10⁻⁵ nm⁻¹ à une fréquence de vibration de liaisons silanols présentes dans la première couche), cela signifie qu'un certain nombre de liaisons silanols (liaisons Si-OH) ont été formées dans la première couche d'oxyde de silicium, c'est-à-dire dans son épaisseur et non uniquement en surface de cette première couche. Par rapport à une couche d'oxyde de silicium standard (SiO₂ ou SiOₓ avec x proche de 2) ne comportant pas de liaisons silanols, la première couche qui comporte une telle densité, ou taux, de liaisons silanols, présente une forte tendance à absorber l'humidité. Or, la présence de groupes -OH et de molécules H₂O incorporés dans l'oxyde de silicium lors de sa réalisation et absorbés par l'environnement affectent les propriétés physiques et mécaniques du matériau. En particulier, cela entraîne une diminution de la dureté et du module d'Young de ce matériau par rapport aux couches déposées de manière standard. Or, cette diminution de la dureté conduit à une augmentation de l'énergie de collage obtenue. Ainsi, il devient possible d'obtenir des énergies de collage pouvant être par exemple supérieures à environ 3 J/m².

La valeur de l'absorbance est exprimée ici en nm⁻¹, c'est-à-dire que l'absorbance mesurée est rapportée à l'épaisseur de la couche dont l'absorbance est mesurée.

La fréquence de vibration des liaisons silanols est égale à environ 3660 cm⁻¹.

La première couche d'oxyde de silicium a une épaisseur supérieure ou égale à environ 10 nm. De plus, les liaisons silanols sont formées dans au moins une partie de l'épaisseur de la première couche supérieure ou égale à environ 10 nm, c'est-à-dire dans une épaisseur d'oxyde de silicium supérieure ou égale à environ 10 nm, c'est-à-dire depuis la surface de la première couche jusqu'à une profondeur supérieure ou égale à environ 10 nm. Cette épaisseur au sein de laquelle les liaisons silanols sont réalisées peut également être supérieure à environ 10 nm, ou supérieure ou égale à environ 20 nm, ou supérieure ou égale à environ 50 nm, ou encore supérieure ou égale à environ 100 nm. Il est par exemple possible que les liaisons silanols soient réalisées dans toute l'épaisseur de la première couche d'oxyde de silicium.

La réalisation de la première couche peut comporter au moins un dépôt de type PECVD (dépôt chimique en phase vapeur assisté par plasma) d'oxyde de silicium sur le premier substrat. Le premier substrat peut être composé de silicium.

La première couche peut être déposée telle qu'elle présente, juste après le dépôt, une tension supérieure ou égale à environ 50 MPa.

La première couche peut être composée d'oxyde de silicium non stoechiométrique obtenu via le dépôt PECVD au cours duquel un réacteur de dépôt est utilisé à une puissance RF inférieure à une puissance RF permettant de déposer du dioxyde de silicium sous sa forme stoechiométrique SiO₂, ou le plus proche de sa forme stoechiométrique SiO₂, formant au moins une partie des liaisons silanols présentes dans la première couche. Ainsi, la formation de liaisons silanols dans la première couche d'oxyde de silicium est au moins en partie obtenue en abaissant la puissance RF du réacteur de dépôt utilisé par rapport à un dépôt standard de SiO₂.

La première couche peut être composée d'oxyde de silicium non stoechiométrique obtenu via le dépôt PECVD mis en oeuvre à partir de précurseurs gazeux d'un premier type (par exemple du TEOS (TétraEthOxySilane), ou du silane, ou du SiₓH_{y}, ou encore du SiF₄) et de précurseurs gazeux oxydant (par exemple du O₂) dont le ratio, c'est-à-dire le rapport entre la quantité de précurseurs du premier type et la quantité de précurseurs oxydant, est supérieur à celui permettant de déposer du dioxyde de silicium sous forme stoechiométrique ou proche de sa forme stoechiométrique, formant au moins une partie des liaisons silanols présentes dans la première couche. Ainsi, sans modifier la puissance RF par rapport à un dépôt classique de SiO₂, il est possible de former des liaisons silanols dans la couche d'oxyde de silicium déposée en jouant sur le rapport des quantités de précurseurs gazeux mis en jeu lors du dépôt, modifiant ainsi la quantité de radicaux dans le plasma créé lors du dépôt.

En variante, il est possible de modifier à la fois le ratio entre les précurseurs gazeux mis en jeu lors du dépôt et d'abaisser la puissance RF du réacteur utilisé pour créer les liaisons silanols dans l'oxyde de silicium déposé.

La réalisation de la première couche peut comporter un dépôt d'oxyde de silicium sur le premier substrat, puis une étape d'hydrolysation de l'oxyde de silicium déposé formant au moins une partie des liaisons silanols présentes dans la première couche.

Dans ce cas, il est possible de déposer tout d'abord une couche de SiO₂ standard ne comportant pas de liaisons silanols, ou une couche d'oxyde de silicium comportant peu de liaisons silanols, puis de procéder ensuite à une hydrolysation de cette couche afin d'obtenir la densité souhaitée de liaisons silanols dans la couche.

La densité des liaisons silanols dans la première couche d'oxyde de silicium n'est pas nécessairement constante dans toute l'épaisseur de cette première couche d'oxyde de silicium dans laquelle sont formées ces liaisons. Par exemple, lorsque la première couche d'oxyde de silicium est réalisée via la mise en oeuvre d'une étape d'hydrolysation, il est possible que la densité des liaisons silanols dans cette couche forme un gradient en fonction de la profondeur à laquelle se trouvent les liaisons silanols, c'est-à-dire que plus la profondeur à laquelle se trouvent les liaisons silanols est importante, plus la densité de ces liaisons silanols à cette profondeur est faible.

Des techniques autres que le dépôt PECVD ou l'hydrolysation peuvent être mises en oeuvre pour réaliser une couche d'oxyde de silicium comprenant des liaisons silanols telles que la valeur de l'absorbance de cette couche, à une fréquence de vibration de liaisons silanols présentes dans la couche, soit égale ou supérieure à environ 1,5.10⁻⁵ nm⁻¹.

Le procédé peut comporter en outre, après le collage direct entre la première couche et la deuxième couche, une étape de recuit de la première couche et de la deuxième couche à une température inférieure ou égale à environ 400°C, par exemple comprise entre environ 200°C et 400°C, pendant une durée comprise entre environ 10 minutes et 10 heures, par exemple égale à 2 heures. On augmente ainsi l'énergie de collage entre les deux couches solidarisées l'une contre l'autre.

Le procédé peut comporter en outre, entre la réalisation de la première couche sur le premier substrat et le collage direct entre la première couche et la deuxième couche, une étape de planarisation mécano-chimique de la première couche et/ou de la deuxième couche. Cette planarisation permet de réduire la rugosité et améliorer le comportement hydrophile des faces de la première couche et de la deuxième couche destinées à être solidarisées l'une contre l'autre, et donc d'augmenter l'énergie de collage obtenue entre ces deux couches.

Lorsque la première couche est déposée directement sur le premier substrat composé de silicium, la première couche peut être réalisée telle que la valeur de son absorbance à la fréquence de vibration des liaisons silanols présentes dans la première couche soit comprise entre environ 1,5.10⁻⁵ nm⁻¹ et 2.10⁻⁵ nm⁻¹. Ainsi, en ne dépassant une absorbance de 2.10-5 nm⁻¹ à la fréquence de vibration des liaisons silanols lorsque la première couche d'oxyde de silicium est déposée directement sur le premier substrat, on évite ainsi la formation ultérieure de défauts, par exemple lors de la mise en oeuvre d'un recuit, à l'interface entre la première couche et le premier substrat, ces défauts pouvant fragiliser la liaison mécanique entre la première couche d'oxyde de silicium et le premier substrat.

Lorsque la première couche est déposée sur une couche barrière recouvrant le premier substrat et composée d'au moins un matériau apte à bloquer la diffusion d'eau depuis la première couche vers premier substrat, la première couche peut être réalisée telle que la valeur de son absorbance à la fréquence de vibration des liaisons silanols présentes dans la première couche soit supérieure à environ 2.10⁻⁵ nm⁻¹. Lorsque la première couche d'oxyde de silicium n'est pas déposée directement sur le premier substrat, mais sur une couche barrière (par exemple composée de nitrure, d'oxyde thermique, de métal, etc.) formée au préalable sur le premier substrat, il est dans ce cas possible et avantageux de maximiser la densité de liaisons silanols dans la première couche afin d'augmenter le plus possible l'énergie de collage.

La deuxième couche de matériau peut être composée d'oxyde de silicium et être réalisée de manière analogue à la première couche. Toutes les caractéristiques précédemment décrites pour la première couche peuvent s'appliquer également pour la deuxième couche.

En variante, la deuxième couche peut être la couche de surface d'un substrat semi-conducteur ou de verre ou de quartz ou de silice.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1C représentent les étapes d'un procédé de collage direct entre une première couche d'oxyde de silicium et une deuxième couche, objet de la présente invention, selon un mode de réalisation particulier;
- la figure 2 représente l'absorbance dans la bande infrarouge mesurée par spectroscopie FTIR en mode transmission pour une première couche d'oxyde de silicium réalisée lors d'un procédé de collage direct, objet de la présente invention, selon un mode de réalisation particulier;
- la figure 3 représente différentes opérations réalisées lors de la mesure de l'absorbance dans la bande infrarouge par spectroscopie FTIR en mode transmission d'une première couche d'oxyde de silicium réalisée lors d'un procédé de collage direct, objet de la présente invention, selon un mode de réalisation particulier;
- la figure 4 représente la structure obtenue après la mise en oeuvre d'un procédé de collage direct entre une première couche d'oxyde de silicium et une deuxième couche, objet de la présente invention, selon un deuxième mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

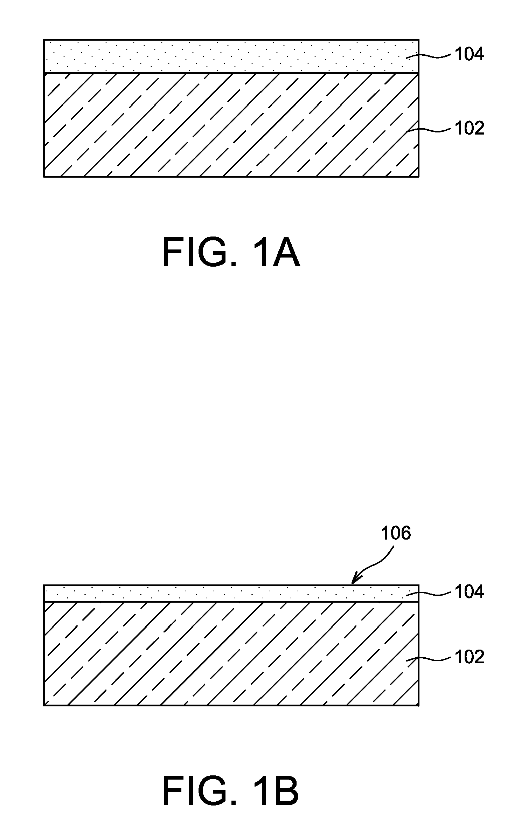

On se réfère tout d'abord aux figures 1A à 1C qui représentent les étapes d'un procédé de collage direct entre au moins une première couche composée d'oxyde de silicium et une deuxième couche de matériau présentant un caractère hydrophile, selon un mode de réalisation particulier.

Comme représenté sur la figure 1A, on réalise tout d'abord le dépôt d'une première couche d'oxyde de silicium 104 sur un premier substrat 102 par exemple composé de silicium. La première couche 104 est de préférence déposée par PECVD à partir de précurseurs gazeux de type TEOS et O₂, mais peut également être obtenue à partir d'autres précurseurs gazeux comme par exemple du silane SiH₄ ou plus généralement des composés de formule générale SiₓH_{y}, ou du sifane SiF₄.

La première couche d'oxyde de silicium 104 peut avoir une épaisseur comprise entre environ 10 nm et 25 µm, ou de préférence comprise entre environ 12 µm et 20 µm notamment lorsque l'on réalise le collage d'une puce sur un wafer, ou entre 10 nm et 2 µm lorsque l'on solidarise deux substrats entre eux. On réalise par exemple ici une couche 104 d'épaisseur égale à environ 600 nm.

Compte tenu des conditions de dépôt (détaillées plus loin) de la première couche 104, l'oxyde de silicium de cette première couche 104 n'est pas un oxyde de silicium sous forme stoechiométrique SiO₂ L'oxyde de silicium composant la première couche 104 est de composition non stoechiométrique de formule SiOₓ, avec x tel que 1 < x < 2. De plus, au cours du dépôt, des atomes de carbone et d'hydrogène peuvent être incorporés à la première couche 104 en raison de réactions chimiques incomplètes se produisant au cours du dépôt. L'oxyde de silicium composant la première couche 104 est alors de composition non stoechiométrique de formule SiOₓC_{y}H_{z}, avec x non nul, y et z pouvant eux être nuls.

La première couche d'oxyde de silicium 104 est ensuite planarisée par CMP (planarisation mécano-chimique) au niveau de sa face avant 106 afin d'améliorer le comportement hydrophile et réduire les rugosités de surface au niveau de la face avant 106 de la première couche d'oxyde de silicium 104 destinée à être collée ultérieurement à la deuxième couche, augmentant ainsi l'énergie de collage qui sera obtenue entre ces deux couches (figure 1B). L'épaisseur de la couche 104 après la CMP est par exemple comprise entre environ 10 nm et 25 µm, et par exemple égale à environ 400 nm.

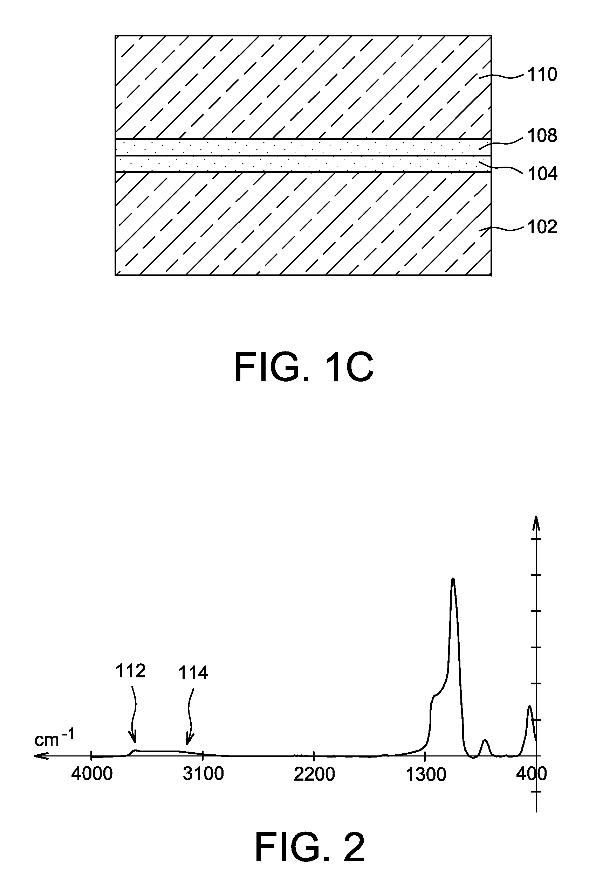

Enfin, comme représenté sur la figure 1C, on réalise ensuite le collage direct de la première couche d'oxyde de silicium 104 contre une deuxième couche 108 présentant un caractère hydrophile, par exemple composée d'oxyde de silicium, déposée contre un deuxième substrat 110 et par exemple réalisée et traitée de manière analogue à la première couche d'oxyde de silicium 104 (conditions de dépôt particulières permettant d'obtenir de l'oxyde de silicium sous forme non stoechiométrique, puis CMP). Un traitement thermique (recuit) à une température par exemple comprise entre environ 200°C et 400°C, pendant une durée comprise entre environ 10 minutes et 10 heures, et par exemple égale à 2 heures, est ensuite mis en oeuvre, achevant le collage direct entre la première couche 104 et la deuxième couche 108.

Dans le procédé décrit ci-dessus, la première couche d'oxyde de silicium 104 (ainsi qu'éventuellement la deuxième couche d'oxyde de silicium 108) est obtenue via un équipement de dépôt PECVD dont le réacteur est utilisé à une faible puissance RF, c'est-à-dire à une puissance RF inférieure à celle permettant de réaliser un dépôt d'oxyde de silicium sous forme stoechiométrique de type SiO₂.

Le dépôt de la première couche d'oxyde de silicium 104 peut être réalisé avec différents types d'équipements de dépôt de type PECVD. Lorsque du TEOS est utilisé comme précurseur gazeux pour déposer la première couche 104, il est par exemple possible d'utiliser deux types de réacteurs qui diffèrent de part la nature de leur système d'injection : le réacteur de type « parallel plate plasma discharge » de l'équipement P5000B basé sur une injection directe, et le réacteur P5000C qui est de type bulleur, tous deux distribués par la société « Applied Materials ».

En raison des différences entre les équipements de dépôt pouvant être utilisés pour déposer la première couche d'oxyde de silicium 104, les puissances RF appliquées diffèrent en fonction de l'équipement utilisé. Pour obtenir la première couche d'oxyde de silicium 104 en utilisant le réacteur P5000B, la puissance RF de ce réacteur est par exemple prise égale à environ 450 W. En utilisant le réacteur P5000C, la puissance RF est par exemple ajustée à environ 500 W.

En abaissant la puissance RF de l'équipement de dépôt PECVD pour déposer la première couche d'oxyde de silicium 104 par rapport à un dépôt classique de SiO₂ sous forme stoechiométrique, on confère à l'oxyde de silicium déposé un caractère hydrophile, c'est-à-dire une tendance à absorber l'humidité, favorisant ainsi la formation de liaisons silanols (liaisons Si-OH) au sein de la première couche d'oxyde de silicium 104. Les liaisons silanols sont notamment formées dans l'épaisseur de la couche 104, depuis sa face avant 106 jusqu'à une profondeur supérieure ou égale à environ 10 nm. Or, la présence de ces liaisons silanols dans la première couche d'oxyde de silicium 104 affecte les propriétés physiques et mécaniques du matériau de la première couche 104. En particulier, elles entraînent une augmentation de la contrainte en tension (par exemple supérieure à environ 50 MPa) ainsi qu'une diminution de la dureté, et donc du module d'Young, du matériau obtenu par rapport à du SiO₂ standard sous forme stoechiométrique. Cette réduction de la dureté du matériau favorise le collage direct réalisé entre la couche d'oxyde de silicium 104 et la deuxième couche d'oxyde de silicium 108 grâce à une plus grande énergie de collage obtenue.

Le tableau ci-dessous donne des exemples de valeurs de l'indice de réfraction, de la permittivité et de la contrainte en tension de couches d'oxyde de silicium déposées en utilisant les réacteurs P5000B et P5000C avec différentes puissances RF. Les couches d'oxyde de silicium obtenues avec le réacteur P5000B utilisé à une puissance RF égale à 750 W et avec le réacteur P5000C utilisé à une puissance RF égale à 675 W correspondent à des couches de SiO₂ standard, tandis que celles obtenues avec le réacteur P5000B utilisé à une puissance RF égale à 450 W et avec le réacteur P5000C utilisé à une puissance RF égale à 500 W correspondent à des couches d'oxyde de silicium similaires à la première couche 104, c'est-à-dire incorporant des liaisons silanols.

| | Indice de réfraction | εᵣ | Tension (MPa) |
|---|---|---|---|
| P5000B - 750W | 1,463 | 4,3 | -101 |
| P5000B - 450W | 1,452 | | 80 |
| P5000C - 675W | 1,463 | 4,3 | -26 |
| P5000C - 500W | 1,450 | | 80 |

Le collage au niveau de l'interface entre la première couche d'oxyde de silicium 104 et la deuxième couche d'oxyde de silicium 108 est obtenu par l'interaction entre les aspérités au niveau des micro-rugosités à travers un mécanisme de friction entre ces deux couches. Au cours du traitement thermique réalisé après avoir mis en contact ces deux couches l'une avec l'autre, les points de contact au niveau des aspérités augmentent la surface de contact, ce qui explique pourquoi l'énergie de collage augmente lorsque la température de traitement augmente. Ainsi, le traitement thermique est de préférence réalisé à une température proche de la limite au-delà de laquelle des éléments en présence sont dégradés (back-end des substrats 102 et 110, comme par exemple des transistors CMOS), par exemple à une température proche de 400°C.

Dans le procédé de collage décrit ici, la surface d'adhésion au niveau des aspérités est améliorée par la diminution de la dureté de l'oxyde de silicium de la première couche 104 et éventuellement de la deuxième couche 108. En effet, en réduisant cette dureté, les sommets des aspérités présentes sur les couches 104 et 108 peuvent facilement être déformés au cours du traitement thermique. Ce mécanisme conduit à une augmentation de l'énergie de collage après le traitement thermique. Ainsi, on obtient une énergie de collage égale à environ 1,3 J/m² pour une couche de SiO₂ déposée avec le réacteur P5000B utilisé à une puissance RF égale à 750 W, et une énergie de collage égale à environ 2,4 J/m² pour la première couche 104 obtenue avec le réacteur P5000C utilisé à une puissance RF égale à 450 W.

Les propriétés mécaniques de l'oxyde de silicium obtenu peuvent être mesurées par exemple par indentation (procédé permettant, en enfonçant une pointe avec une force mesurée dans le matériau et en mesurant la trace obtenue, de remonter au module d'Young réduit du matériau) et comparées avec celles de la silice fondue. Le tableau ci-dessous donne des exemples de valeurs de la dureté et du module d'Young d'une couche de silice fondue, d'une couche de SiO₂ sous forme stoechiométrique déposée avec le réacteur P5000B à une puissance RF égale à 750 W et une couche d'oxyde de silicium obtenue avec le réacteur P5000B fonctionnant à une puissance RF égale à 450 W.

| | Dureté (GPa) | Module d'Young (GPa)(rapport de Poisson = 0,18) |
|---|---|---|
| Silice fondue | 10 | 73,2 |
| P5000B - 750W | 8,3 | 72,7 |
| P5000B - 450W | 6,6 | 60,6 |

Ces données montrent que la couche d'oxyde de silicium déposée à faible puissance RF est celle ayant la plus faible dureté.

Il est possible de prédire l'énergie de collage qui sera obtenue après traitement thermique en mesurant la quantité de groupes -OH et de molécules H₂O formés dans le volume de la couche d'oxyde de silicium avant son collage via l'étude de la bande d'absorption du mode vibrationnel des groupes -OH et des molécules H₂O par spectroscopie FTIR (spectroscopie infrarouge à transformée de Fourrier) en mode transmission. Une telle spectroscopie est basée sur l'absorption d'un rayonnement infrarouge par le matériau analysé. Elle permet, via la détection de vibrations caractéristiques des molécules et liaisons chimiques du matériau, d'effectuer une identification et une quantification des différentes liaisons chimiques présentes dans le matériau. En effet, lorsque l'énergie du faisceau lumineux infrarouge est voisine de l'énergie de vibration d'une liaison chimique, cette dernière va absorber le rayonnement et il est alors possible de mesurer l'intensité réfléchie ou transmise, proportionnelle à la quantité de liaisons chimiques excitées par le faisceau lumineux.

Dans le cas présent, une telle spectroscopie permet donc de quantifier le taux, ou la densité, de liaisons silanols présentes dans la première couche d'oxyde de silicium 104. L'intensité du spectre d'absorbance mesuré dépend de la quantité de liaisons silanols excitées dans le volume du matériau.

La présence de ces composés (groupes -OH et molécules H₂O) se traduit, dans le spectre d'absorbance mesuré, par une bande d'absorption dans la gamme de fréquences de vibration comprises entre environ 3000 et 3800 cm⁻¹. Ce spectre peut être mesuré sur un échantillon d'oxyde de silicium qui a les mêmes caractéristiques que la couche d'oxyde de silicium dont on souhaite connaître les propriétés chimiques. Dans ce cas, l'échantillon est déposé en même temps que la couche d'oxyde de silicium étudiée et le spectre est mesuré juste après la mise en oeuvre de la planarisation de la couche et de l'échantillon.

Les liaisons silanols (Si-OH) peuvent être présentes dans le matériau déposé soit sous forme de liaisons isolées, soit sous forme de liaisons groupées (liées par des liaisons hydrogène). Les liaisons silanols isolées vibrent à une fréquence de vibration égale à environ 3660 cm⁻¹ et forment un pic sur le spectre d'absorbance à cette fréquence. Les liaisons silanols groupées vibrent dans la gamme de fréquences de vibration 3200 - 3600 cm⁻¹.

La figure 2 représente l'absorbance obtenue dans la bande infrarouge de fréquences de vibration comprises entre 400 et 4000 cm⁻¹, correspondant aux longueurs d'onde comprises entre 2,5 et 25 µm, par spectroscopie FTIR en mode transmission mesurée pour la première couche d'oxyde de silicium 104 déposée avec le réacteur P5000B à une puissance de 450 W. La mesure de ce spectre est par exemple réalisée au centre de l'échantillon. A partir de cette absorbance mesurée (exprimée en unité arbitraire), il est possible d'en déduire le taux, ou la densité, des liaisons silanols isolées présentes dans la couche d'oxyde de silicium en mesurant la valeur du pic (référencé 112 sur la figure 2) à 3660 cm⁻¹ car cette valeur est représentative de la valeur de la densité de liaisons silanols multipliée par l'épaisseur de la couche. De plus, la valeur non nulle de l'absorbance dans la gamme 3200 - 3600 cm⁻¹ (référencée 114 sur la figure 2) reflète la présence de liaisons silanols groupées dans la couche d'oxyde de silicium.

Pour améliorer la qualité de collage de la première couche d'oxyde de silicium 104, il convient d'abaisser, lors de la réalisation de la première couche 104, la puissance RF du réacteur utilisé pour le dépôt afin que, lorsque l'on mesure l'absorbance de l'oxyde déposé, celle-ci comporte, à une fréquence de vibration égale à environ 3660 cm⁻¹, un pic de valeur (ou valeur maximale) égale ou supérieure à environ 1,5.10⁻⁵ nm⁻¹ (absorbance mesurée par rapport à l'épaisseur de la couche d'oxyde de silicium déposée).

Dans le cas de couches de SiO₂ stoechiométrique déposées dans des conditions standards de dépôt (forte puissance RF du réacteur utilisé), la valeur du spectre dans la gamme 3000 - 3800 cm⁻¹ est nulle ou quasi-nulle.

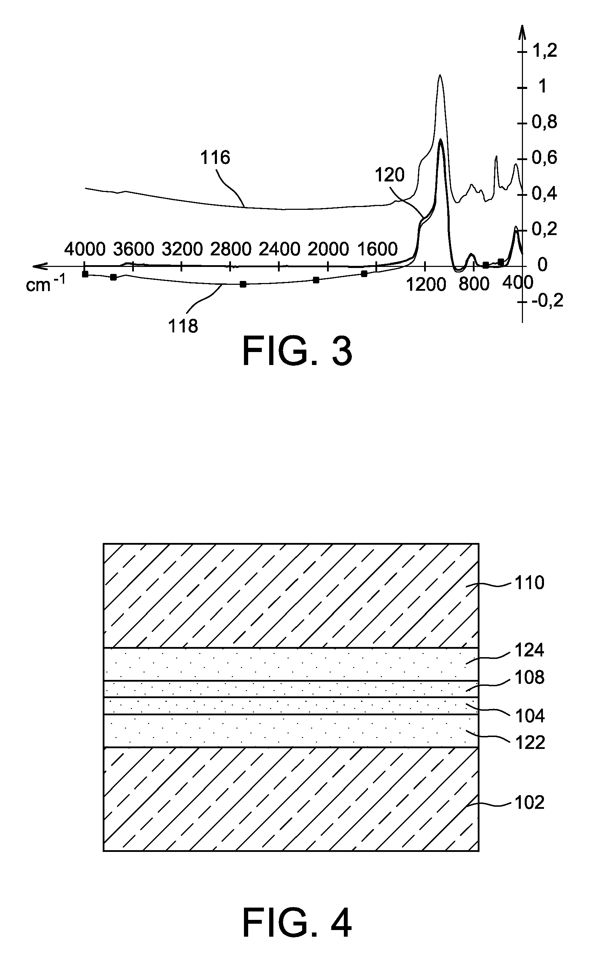

Etant donné que le spectromètre à transformée de Fourier mesure l'absorbance d'une couche d'oxyde de silicium disposée sur un substrat, les données mesurées correspondent à l'absorbance de la structure complète traversée par la source lumineuse de l'équipement de mesure, c'est-à-dire à la fois l'absorbance de la première couche d'oxyde de silicium 104 et celle du premier substrat 102. Le spectromètre utilisé est ici un spectromètre BIORAD type QS500 distribué par Accent Optical Technologies. La courbe 116 représentée sur la figure 3 correspond à l'absorbance mesurée et délivrée en sortie par le spectromètre. L'absorbance de la première couche d'oxyde de silicium 104 seule est obtenue en soustrayant l'absorbance de la structure complète moins celle du premier substrat 102 qui peut être mesurée préalablement au dépôt de la première couche d'oxyde de silicium 104 (voir courbe 118 représentée sur la figure 2). Cette soustraction est par exemple réalisée par un logiciel de traitement tel que Win-IR Pro de la société Bio-Rad. L'absorbance de l'environnement dans lequel se trouve la structure complète peut être soustraite automatiquement par le spectromètre.

La courbe 118 est ensuite linéarisée afin de corriger les décalages et autres phénomènes parasites apparaissant sur la mesure. En effet, le spectre d'absorbance obtenu après soustraction de l'absorbance du substrat présente des valeurs négatives qui ne sont pas cohérentes étant donné que l'échantillon n'émet pas de lumière. Une linéarisation est donc réalisée en décalant certains points du spectre sur l'axe des abscisses correspondant à une valeur d'absorbance nulle. Dans le cas présent où l'on souhaite mesurer la valeur du pic d'absorbance à 3660 cm⁻¹, et afin de pouvoir comparer les spectres d'absorbance de plusieurs couches d'oxyde de silicium entre eux, chaque spectre est linéarisé en décalant les mêmes points sur l'axe des abscisses, par exemple ceux correspondant aux fréquences de vibration égales à 4000 cm⁻¹, 3800 cm⁻¹, 2700 cm⁻¹, 1700 cm⁻¹, 700 cm⁻¹ et 570 cm⁻¹. Après linéarisation, on obtient alors la courbe 120 représentée sur la figure 3 qui correspond à celle représentée sur la figure 2, à partir de laquelle il est possible d'évaluer la densité, ou le taux, de liaisons silanols présentes dans la couche d'oxyde de silicium.

Dans le procédé de collage décrit en liaison avec les figures 1A à 1C, les couches d'oxyde de silicium 104 et 108 sont déposées directement sur les substrats de silicium 102 et 110. Dans ce cas, il convient de ne pas dépasser une trop grande quantité de liaisons silanols dans ces couches afin d'éviter la formation ultérieure de défauts à l'interface entre la première couche 104 et le premier substrat 102 (et éventuellement à l'interface entre la deuxième couche 108 et le deuxième substrat 110 si la deuxième couche 108 comporte des liaisons silanols) lors de la mise en oeuvre du traitement thermique réalisé après la mise en contact des deux couches d'oxyde de silicium 104 et 108 l'une contre l'autre. Ainsi, afin d'augmenter l'énergie de collage d'une couche d'oxyde de silicium tout en évitant la formation ultérieure de défauts à son interface avec le substrat, il convient de choisir une puissance RF du réacteur utilisé pour déposer la première couche d'oxyde de silicium 104 telle que l'absorbance de cette couche d'oxyde de silicium présente un pic, à une fréquence de vibration égale à environ 3660 cm⁻¹, de valeur comprise à environ 1,5.10⁻⁵ nm⁻¹ et 2.10⁻⁵ nm⁻¹.

Dans l'exemple précédemment décrit, la première couche d'oxyde de silicium 104 est déposée directement sur le premier substrat 102 de silicium.

Dans ce cas, on veille à ce que la densité de liaisons silanols dans la première couche d'oxyde de silicium 104 soit telle que le pic d'absorbance à environ 3660 cm⁻¹ ne dépasse pas 2.10⁻⁵ nm⁻¹ afin d'éviter la formation de défauts à l'interface oxyde/substrat.

Il est toutefois possible que la première couche d'oxyde de silicium ne soit pas réalisée directement sur le premier substrat, mais sur une couche barrière déjà présente sur le premier substrat.

Une telle configuration est représentée sur la figure 4. Dans cet exemple, la première couche d'oxyde de silicium 104 est déposée sur une première couche barrière 122 recouvrant le premier substrat 102. Cette première couche barrière 122 est par exemple composée de Si₃N₄ et a une épaisseur par exemple égale à environ 15 nm. Cette première couche barrière 122 pourrait également être composée de métal ou d'un oxyde thermique d'épaisseur égale à environ 50 nm, ou encore composée de TEOS et d'épaisseur égale à environ 200 nm, ou encore composée de n'importe quel matériau apte à former une barrière, c'est-à-dire bloquer la diffusion des liaisons silanols de l'oxyde vers le premier substrat 102, et donc d'isoler la première couche d'oxyde de silicium 104 vis-à-vis du premier substrat 102.

Dans cette variante, la densité de liaisons silanols dans la première couche 104 sera avantageusement telle que le pic d'absorbance à environ 3660 cm⁻¹ soit supérieure à environ 2.10⁻⁵ nm⁻¹ afin d'augmenter l'énergie de collage, la présence de la première couche barrière 122 empêchant la formation de défauts à l'interface entre la première couche d'oxyde 104 et le premier substrat 102, et permettant d'absorber les éléments dégagés lors du collage et qui sont susceptibles de créer ces défauts. Une telle couche barrière 122 peut être déjà présente sur le premier substrat 102 ou être par exemple réalisée par PECVD de manière standard. Dans l'exemple représenté sur la figure 4, la première couche d'oxyde 104 est solidarisée à la seconde couche d'oxyde de silicium 108 qui est également réalisée sur une deuxième couche barrière 124 disposée sur le deuxième substrat 110, permettant d'augmenter également le nombre de liaisons silanols dans la deuxième couche d'oxyde de silicium 108 sans risquer la formation de défauts entre la deuxième couche d'oxyde de silicium 108 et le deuxième substrat 110.

Dans les exemples précédemment décrits, une densité de liaisons silanols telle que le pic d'absorbance à environ 3660 cm⁻¹ soit supérieur à 1.5.10⁻⁵ nm⁻¹ dans une couche d'oxyde de silicium est obtenue en abaissant la puissance RF du réacteur de dépôt utilisé par rapport à celle d'un dépôt standard de SiO₂ stoechiométrique. En variante, une telle densité de liaisons silanols peut être obtenue en modifiant les ratios des gaz précurseurs utilisés lors du dépôt de la couche d'oxyde de silicium, par exemple en augmentant le rapport entre le précurseur gazeux comprenant le silicium et celui comprenant de l'oxygène. Par exemple, pour un dépôt d'oxyde PECVD TEOS Standard avec un réacteur P5000B à une puissance de 750 W, ce ratio sera de 1000 sccm (« standard cubic centimeters per minute », soit un centimètre cube par minute à une température de 0°C et une pression de 101,325 kPa) de O₂ et 1000 mgm (milligrammes) de TEOS. Pour obtenir une densité de liaisons silanols dans une couche d'oxyde de silicium telle que le pic d'absorbance à environ 3660 cm⁻¹ soit supérieur à 1.5.10⁻⁵ nm⁻¹, ce ratio peut être par exemple de 300 sccm de O₂ et 1000 mgm de TEOS pour une puissance de 750 W, permettant d'obtenir une couche d'oxyde de silicium présentant une tension de l'ordre de 50 MPa. Une telle tension pourrait être obtenue en ne modifiant pas le ratio des précurseurs gazeux mais en abaissant la puissance du réacteur P5000B à environ 500 W. Avec le réacteur P5000C, un oxyde standard peut être obtenu avec un ratio de 600 sccm de O₂, 800 sccm de He, du TEOS et une puissance de 650 W. Une telle couche présente une tension compressive comprise entre -50 MPa et -150 MPa.

En abaissant la quantité de O₂ à 300 sccm sans changer les autres paramètres, ou bien en abaissant la puissance à 550 W sans modifier le ratio de précurseurs, on obtient une couche présentant une tension de l'ordre de 50 MPa. De plus, comme précédemment, lorsque la couche d'oxyde de silicium est déposée directement sur un substrat de silicium, il convient de ne pas dépasser une trop grande quantité de liaisons silanols, c'est-à-dire telle que l'absorbance de la couche d'oxyde de silicium présente un pic, à une fréquence de vibration égale à environ 3660 cm⁻¹, de valeur comprise à environ 1,5.10⁻⁵ nm⁻¹ et 2.10⁻⁵ nm⁻¹, afin d'éviter la formation de défauts entre la couche d'oxyde de silicium et le substrat.

Il est également possible de moduler ces deux paramètres (puissance RF du réacteur utilisé pour le dépôt et ratio de gaz précurseurs) pour obtenir la quantité souhaitée de liaisons silanols dans la couche d'oxyde de silicium déposée.

Afin d'augmenter l'énergie de collage d'une couche d'oxyde de silicium, il est également possible de créer des liaisons silanols dans une couche d'oxyde de silicium existante. Pour cela, après avoir déposé la couche d'oxyde de silicium (sous forme stoechiométrique ou non), on réalise une étape d'hydrolysation de la couche d'oxyde de silicium, par exemple en stockant cette couche (avec le substrat sur lequel la couche est déposée) dans un environnement présentant un taux d'humidité non nul ou encore en immergeant la couche d'oxyde de silicium dans de l'eau ou plus généralement un milieu aqueux, formant ainsi des liaison silanols dans l'oxyde de silicium, depuis la surface de la couche et jusqu'à une profondeur supérieure ou égale à environ 10 nm. Cette étape d'hydrolysation peut également être mise en oeuvre pour une couche d'oxyde de silicium comportant déjà des liaisons silanols, c'est-à-dire déposée avec un réacteur fonctionnant à faible puissance RF et/ou avec un ratio de gaz précurseurs ajusté, comme précédemment décrit.

Toutefois, lorsque qu'il convient de ne pas dépasser une certaine densité de liaisons silanols dans la couche d'oxyde de silicium et que la couche comporte déjà une densité de liaisons silanols proche de la densité limite (par exemple proche de la limite
de 2.10⁻⁵ nm⁻¹ lorsque l'oxyde est déposé directement sur le substrat de semi-conducteur), et afin d'éviter d'augmenter encore la densité de liaisons silanols dans la couche d'oxyde de silicium en raison d'un stockage de la couche dans un environnement humide, la couche d'oxyde de silicium peut être stockée dans une atmosphère contrôlée d'azote, ce qui permet d'éviter une absorption d'humidité par la couche d'oxyde de silicium.

Lors de la réalisation de la ou des couches d'oxyde de silicium comportant les liaisons silanols, les techniques mises en oeuvre (par exemple le dépôt PECVD ou encore l'hydrolysation) permettent de diffuser de l'oxygène et de l'hydrogène à une profondeur supérieure ou égale à environ 10 nm, créant ainsi les liaisons silanols à une telle profondeur dans la ou les couches d'oxyde de silicium.

## Revendications

1. Procédé de collage direct entre au moins une première couche (104) composée d'oxyde de silicium d'épaisseur supérieure ou égale à environ 10 nm et une deuxième couche (108) de matériau présentant un caractère hydrophile, comprenant au moins les étapes de :
- réalisation de la première couche (104) sur un premier substrat (102) telle que la valeur de l'absorbance de cette première couche (104), à une fréquence de vibration de liaisons silanols présentes dans la première couche (104) égale à environ 3660 cm⁻¹, soit égale ou supérieure à environ 1,5.10⁻⁵ nm⁻¹, les liaisons silanols étant formées dans au moins une partie de l'épaisseur de la première couche (104), depuis une surface de la première couche (104) jusqu'à une profondeur supérieure ou égale à environ 10 nm ;
- collage direct entre la première couche (104) et la deuxième couche (108).

2. Procédé selon la revendication 1, dans lequel la réalisation de la première couche (104) comporte au moins un dépôt de type PECVD d'oxyde de silicium sur le premier substrat (102).

3. Procédé selon la revendication 2, dans lequel la première couche (104) est déposée telle qu'elle présente, juste après le dépôt, une tension supérieure ou égale à environ 50 MPa.

4. Procédé selon l'une des revendications 2 ou 3, dans lequel la première couche (104) est composée d'oxyde de silicium non stoechiométrique obtenu via le dépôt PECVD au cours duquel un réacteur de dépôt est utilisé à une puissance RF inférieure à une puissance RF permettant de déposer du dioxyde de silicium sous forme stoechiométrique, formant au moins une partie des liaisons silanols présentes dans la première couche (104).

5. Procédé selon l'une des revendications 2 à 4, dans lequel la première couche (104) est composée d'oxyde de silicium non stoechiométrique obtenu via le dépôt PECVD mis en oeuvre à partir de précurseurs gazeux d'un premier type et de précurseurs gazeux oxydant dont le ratio est supérieur de celui permettant de déposer du dioxyde de silicium sous forme stoechiométrique, formant au moins une partie des liaisons silanols présentes dans la première couche (104).

6. Procédé selon l'une des revendications précédentes, dans lequel la réalisation de la première couche (104) comporte un dépôt d'oxyde de silicium sur le premier substrat (102), puis une étape d'hydrolysation de l'oxyde de silicium déposé formant au moins une partie des liaisons silanols présentes dans la première couche (104).

7. Procédé selon l'une des revendications précédentes, comportant en outre, après le collage direct entre la première couche (104) et la deuxième couche (108), une étape de recuit de la première couche (104) et de la deuxième couche (108) à une température inférieure ou égale à environ 400°C pendant une durée comprise entre environ 10 minutes et 10 heures.

8. Procédé selon l'une des revendications précédentes, comportant en outre, entre la réalisation de la première couche (104) sur le premier substrat (102) et le collage direct entre la première couche (104) et la deuxième couche (108), une étape de planarisation mécano-chimique de la première couche (104) et/ou de la deuxième couche (108).

9. Procédé selon l'une des revendications précédentes, dans lequel, lorsque la première couche (104) est déposée directement sur le premier substrat (102) composé de silicium, la première couche (104) est réalisée telle que la valeur de son absorbance, à la fréquence de vibration des liaisons silanols présentes dans la première couche (104), soit comprise entre environ 1,5.10⁻⁵ nm⁻¹ et 2.10⁻⁵ nm⁻¹.

10. Procédé selon l'une des revendications 1 à 8, dans lequel, lorsque la première couche (104) est déposée sur une couche barrière (122) recouvrant le premier substrat (102) et composée d'au moins un matériau apte à bloquer la diffusion des liaisons silanols depuis la première couche (104) vers le premier substrat (102), la première couche est réalisée telle que la valeur de son absorbance, à la fréquence de vibration des liaisons silanols présentes dans la première couche (104), soit supérieure à environ 2.10⁻⁵ nm⁻¹.

11. Procédé selon l'une des revendications précédentes, dans lequel la deuxième couche de matériau (108) est composée d'oxyde de silicium et est réalisée de manière analogue à la première couche (104).

## Patentansprüche

1. Verfahren zum direkten Bonden zwischen zumindest einer ersten Schicht (104), die aus Siliziumoxid in einer Dicke größer oder gleich etwa 10 nm besteht, und einer zweiten Schicht (108) aus einem Material mit hydrophiler Eigenschaft, das zumindest die nachfolgenden Schritte umfasst:
- Herstellen der ersten Schicht (104) auf einem ersten Substrat (102) derart, dass der Absorptionswert dieser ersten Schicht (104) bei einer Schwingungsfrequenz von in der ersten Schicht (104) vorhandenen Silanolbindungen gleich etwa 3660 cm⁻¹ ist, d. h. gleich oder größer als etwa 1,5.10⁻⁵ nm⁻¹, wobei die Silanolbindungen zumindest in einem Teil der Dicke der ersten Schicht (104) ausgehend von einer Oberfläche der ersten Schicht (104) bis zu einer Tiefe größer oder gleich etwa 10 nm gebildet werden;
- direktes Bonden zwischen der ersten Schicht (104) und der zweiten Schicht (108).

2. Verfahren nach Anspruch 1, wobei das Herstellen der ersten Schicht (104) zumindest eine Abscheidung vom Typ PECVD von Siliziumoxid auf das erste Substrat (102) umfasst.

3. Verfahren nach Anspruch 2, wobei die erste Schicht (104) derart abgeschieden wird, dass sie gerade nach der Abscheidung eine Spannung größer oder gleich etwa 50 MPa aufweist.

4. Verfahren nach einem der Ansprüche 2 oder 3, wobei die erste Schicht (104) aus nichtstöchiometrischem Siliziumoxid besteht, das durch die PECVD-Abscheidung gewonnen wird, während der ein Abscheidungsreaktor mit einer HF-Leistung verwendet wird, die geringer ist als eine HF-Leistung, die das Abscheiden von Siliziumdioxid in stöchiometrischer Form gestattet, wodurch zumindest ein Teil der in der ersten Schicht (104) vorhandenen Silanolbindungen gebildet wird.

5. Verfahren nach einem der Ansprüche 2 bis 4, wobei die erste Schicht (104) aus nichtstöchiometrischem Siliziumoxid besteht, das durch die PECVD-Abscheidung gewonnen wird, die ausgehend von gasförmigen Vorläufern eines ersten Typs und von oxidierenden gasförmigen Vorläufern erfolgt, deren Verhältnis größer als dasjenige ist, mit dem Siliziumdioxid in stöchiometrischer Form abgeschieden werden kann, wodurch zumindest ein Teil der in der ersten Schicht (104) vorhandenen Silanolbindungen gebildet wird.

6. Verfahren nach einem der vorangehenden Ansprüche, wobei das Herstellen der ersten Schicht (104) eine Abscheidung von Siliziumoxid auf das erste Substrat (102) und dann einen Schritt der Hydrolyse von dem abgeschiedenen Siliziumoxid umfasst, wodurch zumindest ein Teil der in der ersten Schicht (104) vorhandenen Silanolbindungen gebildet wird.

7. Verfahren nach einem der vorangehenden Ansprüche, ferner umfassend nach dem direkten Bonden zwischen der ersten Schicht (104) und der zweiten Schicht (108) einen Schritt des Temperns der ersten Schicht (104) und der zweiten Schicht (108) bei einer Temperatur unter oder gleich etwa 400 °C für eine Zeitdauer zwischen etwa 10 Minuten und 10 Stunden.

8. Verfahren nach einem der vorangehenden Ansprüche, ferner umfassend zwischen dem Herstellen der ersten Schicht (104) auf dem ersten Substrat (102) und dem direkten Bonden zwischen der ersten Schicht (104) und der zweiten Schicht (108) einen Schritt des chemisch-mechanischen Polierens der ersten Schicht (104) und/oder der zweiten Schicht (108).

9. Verfahren nach einem der vorangehenden Ansprüche, wobei dann, wenn die erste Schicht (104) direkt auf das aus Silizium bestehende erste Substrat (102) aufgetragen wird, die erste Schicht (104) derart hergestellt wird, dass deren Absorptionswert bei der Schwingungsfrequenz der in der ersten Schicht (104) vorhandenen Silanolbindungen zwischen etwa 1,5.10⁻⁵ nm⁻¹ und 2.10⁻⁵ nm⁻¹ liegt.

10. Verfahren nach einem der Ansprüche 1 bis 8, wobei dann, wenn die erste Schicht (104) auf eine Sperrschicht (122) abgeschieden wird, die das erste Substrat (102) überdeckt, und aus zumindest einem Material besteht, das dazu geeignet ist, die Diffusion der Silanolbindungen ausgehend von der ersten Schicht (104) zum ersten Substrat (102) zu sperren, die erste Schicht derart ausgebildet wird, dass deren Absorptionswert bei der Schwingungsfrequenz der in der ersten Schicht (104) vorhandenen Silanolbindungen höher als etwa 2.10⁻⁵ nm⁻¹ liegt.

11. Verfahren nach einem der vorangehenden Ansprüche, wobei die zweite Materialschicht (108) aus Siliziumoxid besteht und in analoger Weise wie die erste Schicht (104) hergestellt wird.

## Claims

1. A direct bonding method between at least a first layer (104) comprising silicon oxide having a thickness equal to or higher than about 10 nm and a second layer (108) of material having hydrophilicity, comprising at least the steps of:
- making the first layer (104) on a first substrate (102) such that the absorbance value of this first layer (104), at a vibration frequency of silanol bonds present in the first layer (104) equal to about 3660 cm⁻¹, is equal to or higher than about 1.5×10⁻⁵ nm⁻¹, the silanol bonds being formed in at least part of the thickness of the first layer (104) from a surface of the first layer (104) to a depth which is equal to or higher than about 10 nm;
- direct bonding between the first layer (104) and the second layer (108).

2. The method according to claim 1, wherein making the first layer (104) includes at least a PECVD type deposition of silicon oxide onto the first substrate (102).

3. The method according to claim 2, wherein the first layer (104) is deposited such that it has, just after the deposition, a tensile stress equal to or higher than about 50 MPa.

4. The method according to one of claims 2 or 3, wherein the first layer (104) comprises non-stoichiometric silicon oxide obtained via the PECVD deposition during which a depositing reactor is used at a RF power lower than a RF power enabling silicon dioxide to be deposited in stoichiometric form, forming at least part of the silanol bonds present in the first layer (104).

5. The method according to one of claims 2 to 4, wherein the first layer (104) comprises non-stoichiometric silicon oxide obtained via the PECVD deposition implemented from gas precursors of a first type and oxidizing gas precursors the ratio of which is higher than that enabling silicon dioxide to be deposited in stoichiometric form, forming at least part of the silanol bonds present in the first layer (104).

6. The method according to one of the preceding claims, wherein making the first layer (104) includes depositing silicon oxide onto the first substrate (102), and then a step of hydrolysing the deposited silicon oxide forming at least part of the silanol bonds present in the first layer (104).

7. The method according to one of the preceding claims, further including, after the direct bonding between the first layer (104) and the second layer (108), a step of annealing the first layer (104) and the second layer (108) at a temperature equal to or lower than about 400°C for a period of time between about 10 minutes and 10 hours.

8. The method according to one of the preceding claims, further including, between making the first layer (104) on the first substrate (102) and the direct bonding between the first layer (104) and the second layer (108), a step of chemical mechanical planarization of the first layer (104) and/or the second layer (108).

9. The method according to one of the preceding claims, wherein, when the first layer (104) is directly deposited onto the first substrate (102) comprising silicon, the first layer (104) is made such that its absorbance value, at the vibration frequency of the silanol bonds present in the first layer (104), is between about 1.5×10⁻⁵ nm⁻¹ and 2×10⁻⁵ nm⁻¹.

10. The method according to one of claims 1 to 8, wherein, when the first layer (104) is deposited onto a barrier layer (122) covering the first substrate (102) and comprising at least one material able to block diffusion of silanol bonds from the first layer (104) to the first substrate (102), the first layer is made such that its absorbance value, at the vibration frequency of the silanol bonds present in the first layer (104), is higher than about 2×10⁻⁵ nm⁻¹.

11. The method according to one of the preceding claims, wherein the second layer (108) of material comprises silicon oxide and is made analogously to the first layer (104).
